# EUROPEAN PATENT SPECIFICATION

(11) **EP 2 363 926 B1**
(45) Date of publication and mention of the grant of the patent: **22.08.2012**
(21) Application number: 11000825.7
(22) Date of filing: 02.02.2011
(51) Int. Cl.: H01R 43/20, G01R 31/04

(54) **Connector assembling jig**
Verbindermontagevorrichtung
Dispositif d'assemblage de connecteur

(30) Priority: 03.03.2010 JP 2010046868
(43) Date of publication of application: 07.09.2011
(73) Proprietor: Sumitomo Wiring Systems, Ltd., Yokkaichi-city, Mie 510-8503 (JP)
(72) Inventor: Goto, Yuichi, Yokkaichi-City Mie 510-8503 (JP); Horiuchi, Hidefumi, Yokkaichi-City Mie 510-8503 (JP)
(74) Representative: Müller-Boré & Partner Patentanwälte

(56) References cited:
- US-A- 5 701 079
- US-A- 5 718 603
- US-A- 5 877 622

## Description

The present invention relates to a connector assembling jig provided with a terminal insufficient insertion detecting function.

A connector assembling jig disclosed in Japanese Unexamined Patent Publication No. 2000-147047 is conventionally known as the one used to assemble terminal fittings into a connector housing, and this connector assembling jig is provided with a function of detecting a mounted state of the terminal fittings. This detecting function is for checking whether or not a connector is properly assembled by confirming whether or not a retainer formed as a separate member for locking the terminal fittings inserted into the connector housing projects from a proper mount position.

Since this detecting function is for checking the mounted state at the same time as the retainer as a member separate from the connector housing is fully locked in the connector housing, it is difficult to apply such a detecting function to a connector housing in which terminal fittings are locked without a retainer being mounted.

Thus, in recent years, studies have been made on a connector assembling jig provided with a detecting function which copes with a connector housing only in which locking pieces for locking terminal fittings are provided. The connector assembling jig provided with this detecting function is so constructed as to hold a connector housing in a holder including an accommodating recess for accommodating the connector housing when terminal fittings are inserted into the connector housing including terminal accommodating portions and check a mounted state of the terminal fittings by detecting locking pieces projecting from an outer surface of the connector housing in insufficiently inserted states of the terminal fittings.

However, since the connector housing is inserted into the accommodating recess, a small clearance needs to be provided between the accommodating recess and the connector housing. In the above construction, when being arranged in the accommodating recess, the connector housing may possibly shake in a width direction. Also when the terminal fittings are assembled into the connector housing, the piece. During inspection, the detector portion enters the space adjacent the support piece so that the continuity-test surface contacts a terminal lug in the fullyinserted position in the accommodating chamber.

Further, document US 5,701,079 A discloses a connector terminal checking device comprising a base plate, a checking body movably mounted on the base plate, and a connector holder fixed onto the base plate, wherein the checking body further comprises a plurality of check pins aligned facing toward the connector holder, and the connector holder is provided with a terminal holding wall formed with a plurality of terminal position regulating sections, each for receiving a corresponding one of a plurality of terminal accommodating chambers of a connector to be checked, and also provided with a pair of connector sustainers shiftably urged by way of a resilient stuff, wherein by shifting the checking body toward the connector installed in the connector holder to bring the terminals in the connector into contact with the check pins, the terminals improperly inserted in the accommodating chamber are abutted against the terminal position regulating section and shifted to the properly inserted position.

The present invention was developed in view of the above situation and an object thereof is to provide an assembling jig which can improve accuracy of a detecting function by eliminating the shaking of a connector housing arranged in an accommodating recess and can be commonly used for connector housings with different numbers of terminal accommodating portions.

This object is solved according to the invention by the features of the independent claims. Preferred embodiments of the invention are subject of the dependent claims.

According to the invention, there is provided a connector assembling jig which is usable for a connector housing, comprising: a holder including an accommodating recess for at least partly accommodating the connector housing while positioning the connector housing, a base portion including a holder accommodating portion for at least partly accommodating the holder, and an insufficient insertion detecting mechanism for detecting that a terminal fitting is insufficiently inserted in the connector housing, wherein the insufficient insertion detecting mechanism is provided in the holder and is set to an insufficient insertion detecting state when an locking piece of the connector housing projects outward from the one side surface of a housing main body of the connector housing, wherein: the holder is slidable in the accommodating portion between a first position and a second position, wherein in the first position one end of the holder at an opening side projects from an opening of the base portion so that the connector housing can be at least partly inserted into the accommodating recess, and wherein in the second position, the holder is substantially completely accommodated in the holder accommodating portion, at least one positioning groove adapted to receive at least one positioning rib projecting in a thickness direction of the connector housing is formed in an inner side surface of the accommodating recess, and an inner surface of the positioning groove is formed to substantially be flush and continuous with an inner side surface of the accommodating recess adjacent to the inner side surface where the positioning groove is formed.

The present invention is preferably embodied to have the following constructions.

The positioning groove substantially may extend in an inserting direction of the connector housing from the opening edge of the accommodating recess.

According to a particular embodiment, the connector assembling jig which is used for a connector housing including a housing main body with terminal accommodating portions and locking pieces for locking and retaining terminal fittings inserted to proper positions in the terminal accommodating portions and formed such that each locking piece projects outward from one side surface of the housing main body in a state where the corresponding terminal fitting is insufficiently inserted in the terminal accommodating portion, and holds the connector housing and enables detection of insufficient insertion of the terminal fittings when the terminal fittings are inserted into the connector housing, may comprise:
a holder including an accommodating recess for accommodating the connector housing while positioning the connector housing, and
an insufficient insertion detecting mechanism which is provided in the holder and set to an insufficient insertion detecting state when any locking piece of the connector housing projects outward from the one side surface of the housing main body,
wherein:
   a positioning groove extending in an inserting direction of the connector housing from the opening edge of the accommodating recess and adapted to receive a positioning rib projecting in a thickness direction of the connector housing is formed in an inner side surface of the accommodating recess, and
   an inner surface of the positioning groove is formed to be flush and continuous with an inner side surface of the accommodating recess adjacent to the inner side surface where the positioning groove is formed.

According to the connector assembling jig thus constructed, the positioning rib is accommodated into the positioning groove formed in the accommodating recess when the connector housing is inserted into the accommodating recess of the holder, and the outer side surfaces of the connector housing and the positioning rib are in contact with the inner side surface where the positioning groove and the accommodating recess are flush and continuous with each other, whereby the connector housing can be prevented from being inclined in a width direction and shaking. Further, since the positioning groove and the accommodating recess are flush and continuous with each other, a contact part with the connector housing and the outer side surface of the positioning rib increases as compared with the case where there is an angle between the inner side surface of the positioning groove and that of the accommodating recess, wherefore the shaking of the connector housing can be prevented more. Furthermore, also in the case of assembling a connector housing accommodating fewer terminals than a predetermined connector housing, a connector can be assembled without the connector housing shaking by inserting a positioning rib into the positioning groove and assembling terminal fittings.

At least one small connector assisting groove having the same shape as the positioning groove may be provided in a central part of the side surface of the accommodating recess where the positioning groove is formed.

According to this construction, two small connector housings each dimensioned such that a side surface opposite to the one where a positioning rib is provided is held in close contact with the inner side surface of the accommodating recess opposite to the one where the positioning groove is formed when the small connector housing is inserted into the accommodating recess by inserting the positioning rib into the small connector assisting groove can be simultaneously inserted into the accommodating recess and terminal fittings can be assembled thereinto.

At this time, one small connector can be assembled without shaking by inserting the positioning rib of one small connector housing into the positioning groove of the accommodating recess, and another small connector can be assembled without shaking with the side surface of the other connector housing where the positioning rib is provided held in close contact with the inner side surface of the accommodating recess opposite to the one where the positioning groove is formed by inserting the positioning rib into the small connector assisting groove.

Further preferably, the insufficient insertion detecting mechanism comprises a detection arm supported rotatably about a supporting shaft provided in the holder and displaceable between an insufficient insertion detecting posture and a non-detecting posture according a projecting state of the locking piece from the housing main body when the terminal fitting is inserted into the connector housing preferably with the holder at the second position.

Still further preferably, the connector assembling jig further comprises a locking mechanism which is provided from the holder to the base portion for locking the holder at the second position when the detection arm is in the detecting posture, and enables the holder to slide toward or to the first position when the detection arm is in the non-detecting posture.

Most preferably, the holder is mounted slidably between a first position where the connector housing can be accommodated into a base portion holding the holder and a second position where the terminal fittings can be inserted into the connector housing accommodated in the holder, the insufficient insertion detecting mechanism is formed by a detection arm supported rotatably about a supporting shaft provided in the holder and displaceable between an insufficient insertion detecting posture and a non-detecting posture according a projecting state of the locking piece from the housing main body when the terminal fitting is inserted into the connector housing at the second position, and the connector assembling jig further comprises a locking mechanism which is provided from the holder to the base portion for locking the holder at the second position when the detection arm is in the detecting posture, and enables the holder to slide to the first position when the detection arm is in the non-detecting posture.

According to this construction, since the detection arm is set to the insufficient insertion detecting posture depending on the projecting amount of the locking piece to lock the holder at the second position in the insufficiently inserted state of the terminal fitting, whether or not all the terminal fittings have been completely inserted into the connector housing can be judged by confirming whether or not the holder is slidable to the first position after the terminal fittings are inserted into the connector housing without separately checking assembled states of the terminal fittings. Further, there is no likelihood of damaging the locking pieces and the connector housing since no external force other than a force for displacing the posture of the detection arm acts on the locking pieces.

Preferably, the detection arm includes a locking-piece contact portion which can come into contact with the one or more locking pieces and a locking-mechanism contact portion which acts on the locking mechanism depending on the detecting posture.

Further preferably, a dimension from the supporting shaft to the locking-mechanism contact portion is set to be longer than a dimension from the supporting shaft to the locking-piece contact portion.

Most preferably, the detection arm includes a locking-piece contact portion which can come into contact with the locking pieces and a locking-mechanism contact portion which acts on the locking mechanism depending on the detecting posture, and a dimension from the supporting shaft to the locking-mechanism contact portion is longer than a dimension from the supporting shaft to the locking-piece contact portion.

According to this construction, since the projecting amount of the locking piece in the insufficiently inserted state of the terminal fitting acts on the locking-mechanism contact portion after being multiplied, the insufficiently inserted state of the terminal fitting can be reliably detected even if the locking piece projects only by a small amount.

Preferably, the locking mechanism includes a lock portion provided in the holder and slidable in a direction crossing a sliding direction of the holder between a lock position where the lock portion is engaged with an engaging recess formed in the base portion to lock the holder at the second position when the holder is slid to the second position and a non-lock position where the lock portion is disengaged from the engaging recess to unlock the holder, preferably an unlock portion provided in the base portion and slidable in the substantially same direction as the holder between an unlock position where the unlock portion slides in contact with an unlock sliding portion provided at the leading end of the lock portion to slide the lock portion in a direction substantially opposite to an engaging direction with the engaging recess, thereby disengaging the engaging recess and the lock portion, and a non-unlock position where the unlock portion is fixed in the base portion and holds the lock portion and the engaging recess in a locked state, and further preferably a stopper provided in the holder and slidable in the substantially same direction as the lock portion between a restricting position where the stopper is engaged with an engaging groove formed in the base portion and restricts the unlock portion at the non-unlock position by being pushed by the detection arm when the detection arm is in the detecting posture and a non-restricting position where the stopper is disengaged from the engaging groove to free the unlock portion.

According to this construction, it is not necessary to fix the holder at the second position upon inserting the terminal fittings into the terminal accommodating portions, and whether or not all the terminal fittings have been completely inserted into the connector housing can be very easily confirmed based on whether or not the unlock portion is slidable.

Preferably, a stopper biasing member is supported on the stopper for biasing stopper toward a detection-arm accommodating groove of the holder.

Preferably, the holder includes a retaining portion for retaining the connector housing inserted in the holder preferably when the holder is at the second position. According to this construction, the retaining portion retains the connector housing at the second position and the connector housing cannot be taken out in the insufficiently inserted state of the terminal fitting. This can prevent the connector housing from being erroneously taken out from the accommodating recess and can prevent damages of the connector housings and the locking pieces.

Further preferably, the positioning groove has a depth which is set to less than about half of a thickness of the connector housing to be inserted into the accommodating recess, and/or the width of the positioning groove is set to be more than a depth of the positioning groove .

According to the above, it is possible to provide an assembling jig which can be commonly used for connector housings with different numbers of terminal accommodating portions by eliminating the shaking of the connector housing arranged in an accommodating recess.

These and other objects, features and advantages of the present invention will become more apparent upon reading of the following detailed description of preferred embodiments and accompanying drawings. It should be understood that even though embodiments are separately described, single features thereof may be combined to additional embodiments.
FIG. 1 is a perspective view showing a connector housing in which a terminal fitting is inserted,
FIG. 2 is a side view in section showing a state before the terminal fitting is inserted into the connector housing,
FIG. 3 is a side view in section showing a state where the terminal fitting is at a proper position,
FIG. 4 is a side view in section showing a state where the terminal fitting is insufficiently inserted,
FIG. 5 is a front view showing a state where a connector housing including eight terminal accommodating portions is inserted in an accommodating recess of a connector assembling jig according to this embodiment,
FIG. 6 is a front view showing a state where a connector housing including six terminal accommodating portions is inserted in the accommodating recess of the connector assembling jig according to this embodiment,
FIG. 7 is a front view showing a state where a connector housing including four terminal accommodating portions is inserted in the accommodating recess of the connector assembling jig according to this embodiment,
FIG. 8 is a side view in section showing a state where the connector housing is inserted into a holder located at a first position,
FIG. 9 is a side view in section showing a state where the terminal fitting is inserted to a proper position in the connector housing accommodated in the holder located at a second position,
FIG. 10 is a side view in section showing a state where an unlock portion is located at an unlock position, and
FIG. 11 is a side view in section showing a state where the terminal fitting is insufficiently inserted in the connector housing accommodated in the holder located at the second position.

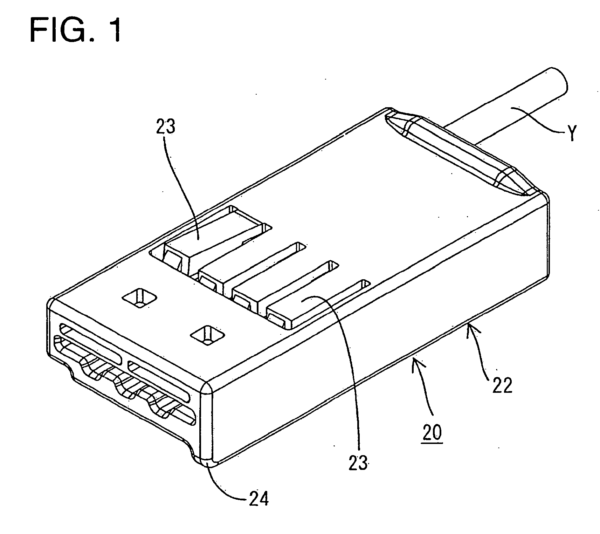

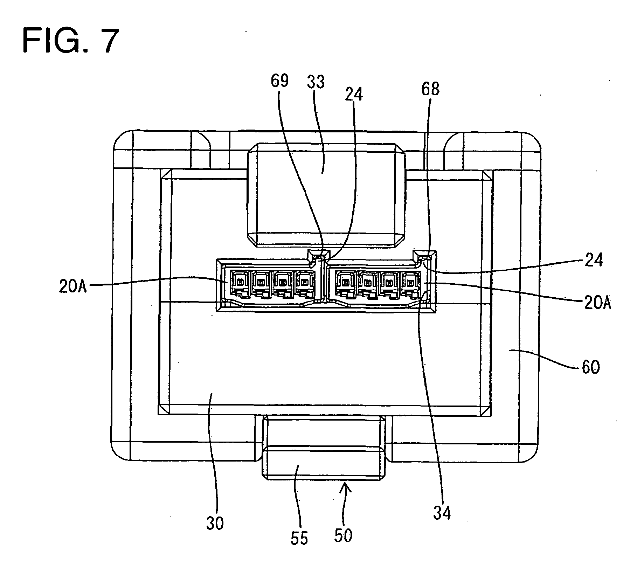

One particular embodiment of the present invention is described with reference to FIGS. 1 to 11.

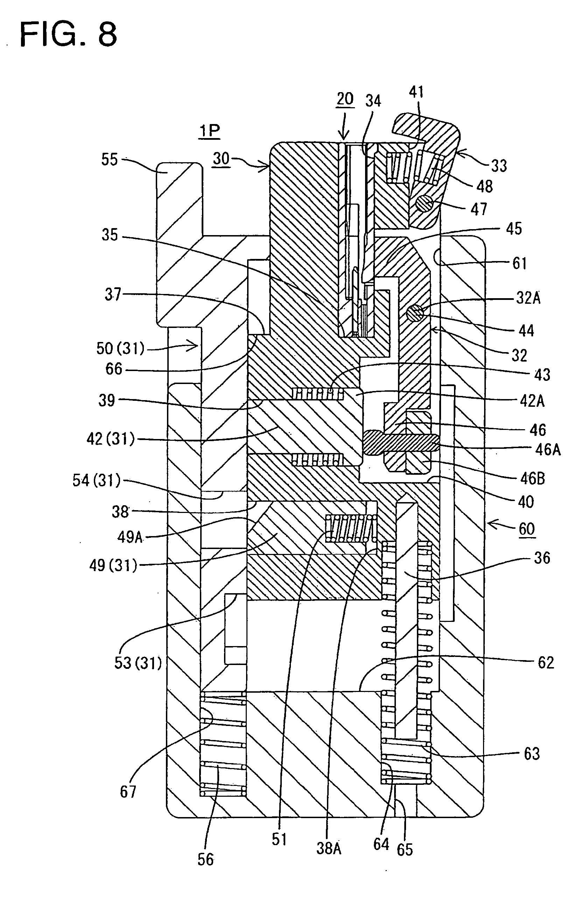

A connector assembling jig of this embodiment particularly has a substantially rectangular parallelepipedic box-like overall external appearance and, as shown in FIG. 8, includes a holder 30 for at least partly accommodating a connector housing 20 with one or more terminal accommodating portions 21, a base portion 60 for holding the holder 30, a locking mechanism 31 provided from the holder 30 to the base portion 60, at least one detection arm 32 equivalent to or as a particular an insufficient insertion detecting mechanism for detecting that a terminal fitting 10 is insufficiently inserted in the connector housing 20, and a retaining portion 33 for retaining the connector housing 20 in the holder 30. For the sake of description, a connector to be assembled in this connector assembling jig is described first. Note that vertical and lateral directions in the following description are based on those of FIG. 8 in this embodiment, and front and rear sides in an inserting direction of the connector housing are respectively referred to as "front" side and "rear" side.

As shown in FIGS. 1 to 4, this connector particularly has a flat and substantially rectangular parallelepipedic external appearance and is provided with a housing main body 22 including the one or more terminal accommodating portions 21, one or more terminal fittings 10 to be mounted into the terminal accommodating portions 21, and a connector housing 20 made e.g. of synthetic resin and including one or more locking pieces 23 for locking the one or more respective terminal fittings 10 at least partly inserted in the terminal accommodating portions 21.

One or more, particularly a plurality of terminal accommodating portions 21 with open front and rear ends are formed (particularly substantially side by side) in the housing main body 22, the respective terminal fittings 10 can be at least partly accommodated into the one or more terminal accommodating portions 21 from an insertion side, particularly substantially from behind, and one or more unillustrated mating terminal fittings to be connected to the respective terminal fittings 10 can be at least partly inserted thereinto from a connection side or from front. The locking piece 23 formed integrally or unitarily to one side surface of the housing main body 22 is provided in each terminal accommodating portion 21. The (particularly substantially strip-like) locking pieces 23 are formed substantially side by side to extend from an intermediate part (particularly a substantially middle part) of the side surface of the housing main body 22 to positions near a middle or intermediate position between the front end surface of the housing main body 22 and the central part.

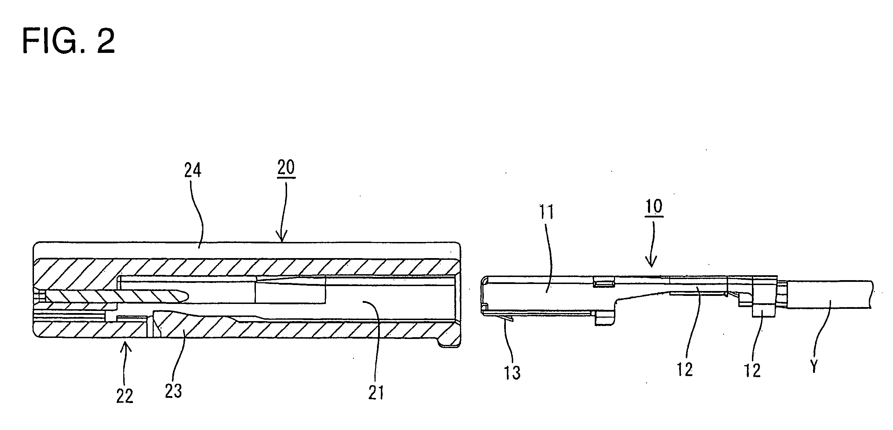

As shown in FIG. 2, each terminal fitting is formed such that a barrel 12 to be crimped and connected to a wire Y is provided behind a connecting portion 11 substantially in the form of a rectangular tube, and a locking claw 13 projecting outward is formed on one of the outer surfaces of the connecting portion 11. The terminal fitting 10 is inserted into the terminal accommodating portion 21 of the connector housing 20 such that the surface where the locking claw 13 is provided comes into contact with a surface of the terminal accommodating portion 21 where the locking piece 23 is provided.

Each locking piece 23 is supported on the housing main body 22 particularly at its base end at the position substantially in the central or intermediate part of the housing main body 22 and resiliently deformable with the base end portion as a supporting point. When the terminal fitting 10 is at least partly inserted into the terminal accommodating portion 21, the locking piece 23 is pressed by the connecting portion 11 of the terminal fitting 10, whereby the locking piece 23 is resiliently deformed outwardly from the terminal accommodating portion 21 and a leading end portion of the locking piece 23 projects from the outer surface of the housing main body 22. When the terminal fitting 10 is at least partly inserted to a proper connection position, the locking piece 23 resiliently at least partly returns and the locking claw 13 of the connecting portion 11 of the terminal fitting 10 is engaged with the locking piece 23, whereby the outer surface of the locking piece 23 and that of the housing main body 22 particularly become substantially flush.

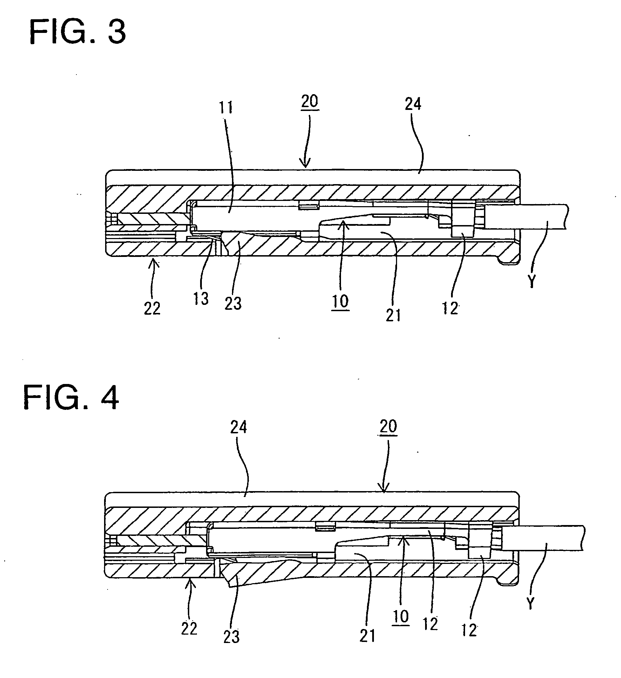

Specifically, when the terminal fitting 10 is insufficiently inserted in the terminal accommodating portion 21, the locking claw 13 of the terminal fitting 10 presses the locking piece 23 so that the locking piece 23 projects outwardly from one longer side surface of the housing main body 22 as shown in FIG. 4.

Next, the connector assembling jig is described in detail.

The holder 30 of the connector assembling jig particularly has a substantially rectangular parallelepipedic box-like external appearance, and a (particularly substantially rectangular) accommodating recess 34 for at least partly accommodating the connector housing 20 described above is formed in an intermediate part (particularly a central part) of the upper or outer surface of the holder 30. An opening of the accommodating recess 34 is formed such that opening edges along the longer sides substantially are parallel to longer outer surface portions of the holder 30.

This accommodating recess 34 has the substantially same cross-sectional shape from the opening to a bottom wall 35 thereof and can hold the connector housing 20 therein.

A length from the bottom wall 35 of this accommodating recess 34 to the opening particularly is set to be substantially equal to the length of the connector housing 20 in a terminal fitting inserting direction. When the connector housing 20 is inserted into the accommodating recess 34, the rear end surface of the connector housing 20 and a surface of the holder 30 where the opening is formed particularly become substantially flush.

Further, the length of the opening of the accommodating recess 34 along the shorter sides particularly is set to be substantially equal to the thickness of the connector housing 20. When the connector housing 20 is inserted into the accommodating recess 34, surfaces of the accommodating recess 34 along the longer sides and surfaces of the connector housing 20 along the longer sides substantially are held in close contact.

This holder 30 is at least partly covered by the base portion 60 which serves as an outer peripheral wall of the connector assembling jig.

The base portion 60 particularly has a substantially rectangular parallelepipedic external appearance and/or is internally formed with a holder accommodating portion 61 for at least partly accommodating the holder 30. The holder accommodating portion 61 is open in the same direction as the opening direction of the accommodating recess 34 of the holder 30 to be at least partly accommodated and/or has an opening with substantially the same rectangular shape formed by the outer circumferential surface of the holder 30. When the holder 30 is completely accommodated in the holder accommodating portion 61, the surface of the holder 30 where the accommodating recess 34 is formed and the surface of the base portion 60 where the holder accommodating portion 61 is formed particularly are substantially flush.

The holder 30 is slidable in the holder accommodating portion 61 between a first position 1 P where the holder 30 is closest to the opening and a second position 2P where the holder 30 is substantially completely accommodated in the holder accommodating portion 61.

When the holder 30 is slid towards or to the first position 1 P, one end of the holder 30 at an opening side projects from the opening of the base portion 60 so that the connector housing 20 can be at least partly inserted into the accommodating recess 34. When the holder 30 is slid towards or to the second position 2P, the surface of the base portion 60 with the opening (opening of the holder accommodating portion 61), the surface of the holder 30 with the opening (opening of the accommodating recess 34) and the surface of the connector housing 20 with the openings (openings of the terminal accommodating portions 21) particularly are substantially flush.

A holder pressing spring 63 for biasing the holder 30 toward the first position 1 P is arranged between a spring recess 64 formed in a back wall 62 of the holder accommodating portion 61 of the base portion 60 and the holder 30, and supported on a spring guide 36 projecting from the lower surface of the holder 30 and at least partly inserted into a guide through hole 65 formed in the base portion 60. Thus, a locking portion 66 engageable with an engaging portion 37 provided in an intermediate part (particularly substantially in a central part) of an outer surface of the holder 30 is provided on an inner surface of the holder accommodating portion 61 to retain the holder 30 biased toward the first position in the holder accommodating portion 61.

On the other hand, a lock-portion accommodating recess 38 and a stopper accommodating recess 39 are formed in one surface substantially along the longer side of the holder 30 out of the surfaces of the holder 30 adjacent to the surface where the accommodating recess 34 is formed and/or held substantially in contact with the inner surfaces of the holder accommodating portion 61, and a detection-arm accommodating groove 40 and a retaining-portion accommodating groove 41 are formed in a substantially opposite surface of the holder 30.

The stopper accommodating recess 39 particularly is so formed at a position slightly displaced toward the lock-portion accommodating recess 38 from the center of the holder 30 as to substantially have a circular cross section and reach the detection-arm accommodating groove 40 located at the opposite side, and a cylindrical stopper 42 having a flange 42A formed at one end toward the detection-arm accommodating groove 40 is at least partly accommodated in the stopper accommodating recess 39 slidably in a direction at an angle different from 0° or 180°, preferably substantially orthogonal to a sliding direction of the holder 30. A part of the stopper accommodating recess 39 particularly is somewhat widened from its substantially central part to the detection-arm accommodating groove 40, and a stopper spring 43 supported on the stopper 42 for biasing the flange 42A toward the detection-arm accommodating groove 40 is provided or mounted particularly in this widened part.

This stopper 42 is slidable between a non-restricting position where it is completely accommodated in the stopper accommodating recess 39 and a restricting position where it projects from the stopper accommodating recess 39 to retain the holder 30 at the second position 2P in the holder accommodating portion 61 by being pressed by the detection arm 32 from the side of the detection-arm accommodating groove 40, and particularly biased toward the non-restricting position by the stopper spring 43.

The detection-arm accommodating groove 40 particularly is formed substantially straight from a position between an intermediate part (particularly substantially the center) of the holder 30 and the lower surface thereof to a position between the upper surface of the holder 30 to the intermediate part (particularly substantially the center) thereof and has a width slightly longer than the width of the detection arm 32, and a supporting shaft 44 for rotatably supporting the detection arm 32 in the detection-arm accommodating groove 40 is provided in (particularly a substantially central part of) the detection-arm accommodating groove 40. At the bottom surface of the detection-arm accommodating groove 40, an end of the detection-arm accommodating groove 40 toward the accommodating recess 34 of the holder 30 substantially communicates with the accommodating recess 34, and an end thereof toward the stopper accommodating recess 39 communicates with the stopper accommodating recess 39.

The detection arm 32 particularly substantially is in the form of a narrow and long box linking communicating openings with the accommodating recess 34 and the stopper accommodating recess 39 in the detection-arm accommodating groove 40, and a locking-piece contact portion 45 is provided at or near an end thereof toward the accommodating recess 34, and a locking-mechanism contact portion 46 (particularly including an adjustment bolt 46A and an adjustment nut 46B) is provided at or near an end thereof toward the stopper accommodating recess 39.

The detection arm 32 is rotatably or pivotably supported by the supporting shaft 44 at least partly inserted through a shaft hole 32A formed in the width direction at a position of the detection arm 32 displaced toward the locking-piece contact portion 45 from the center, and is displaceable between an insufficient insertion detecting posture and a non-detecting posture according to projecting states of the locking pieces 23 of the connector housing 20 with the holder 30 located at the second position 2P.

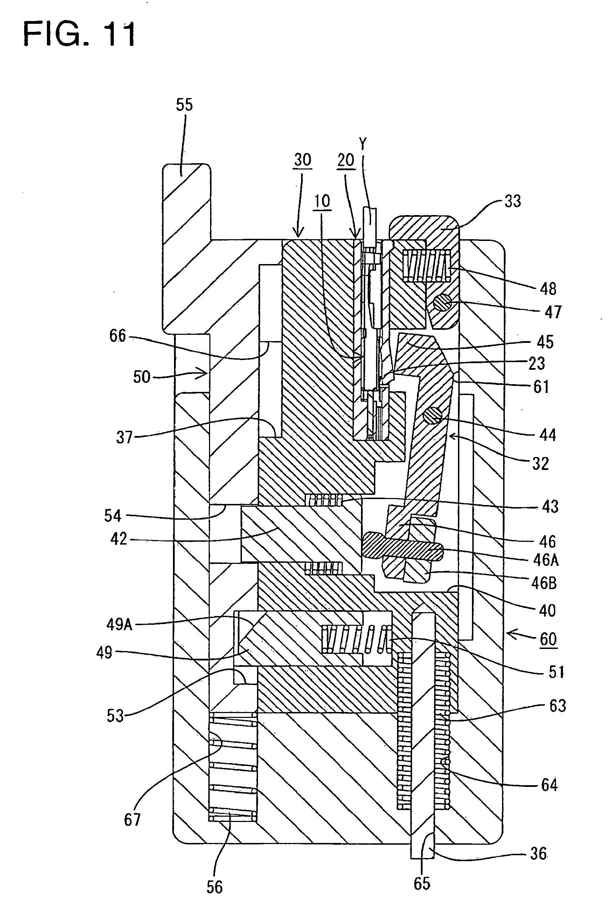

Specifically, as shown in FIG. 11, when the terminal fitting 10 is insufficiently inserted in the connector housing 20, the locking piece 23 projects toward the detection-arm accommodating groove 40 from the accommodating recess 34 of the holder 30 to press the locking-piece contact portion 45, whereby the detection arm 32 rotates or pivots clockwise about the supporting shaft 44 to the insufficient insertion detecting posture to cross an extending directing of the accommodating recess 34. When the terminal fittings 10 are inserted up to the proper positions in the connector housing 20, the locking pieces 23 do not press the locking-piece contact portion 45 toward the detection-arm accommodating groove 40, the projecting surface of the locking-piece contact portion 45 extends substantially along the outer surface of the housing main body 22 and the detection arm 23 is in the non-detecting posture to substantially extend in parallel to the extending direction of the accommodating recess 34.

When the detection arm 32 is in the insufficient insertion detecting posture, the locking-mechanism contact portion 46 of the detection arm 32 pushes the biased stopper 46 out of the stopper accommodating recess 39 and causes the stopper 46 towards or to slide or displace to the restricting position, thereby retaining the holder 30 at the second position in the holder accommodating portion 61.

At this time, for example, the detection arm 32 particularly is set such that a dimension from the supporting shaft 44 to the locking-mechanism contact portion 46 is more than about twice, particularly about three times as long as a dimension from the supporting shaft 44 to the locking-piece contact portion 45. Thus, when a projecting amount of the locking piece 23 is transferred to the locking-piece contact portion 45 to displace the detection arm 32, this projecting amount is transferred to the locking-mechanism contact portion 46 while being multiplied (e.g. three-fold), wherefore the projecting state of the locking piece 23 can be more reliably detected.

The retaining-portion accommodating groove 41 particularly substantially extends from the upper surface of the detection-arm accommodating groove 40 to the surface of the holder 30 where the opening of the accommodating recess 34 is formed, thereby being formed integrally to the detection-arm accommodating groove 40, and a substantially L-shaped retaining portion 33 is mounted in the retaining-portion accommodating groove 41.

This retaining portion 33 has one end thereof rotatably or pivotably supported by a retaining-portion supporting shaft 47 provided in the retaining-portion accommodating groove 41, and is displaceable between a locking posture for retaining the connector housing 20 at least partly accommodated in the accommodating recess 34 and an unlocking posture for enabling the connector housing 20 at least partly accommodated in the accommodating recess 34 to be taken out. A retaining portion spring 48 is mounted between the retaining portion 33 and the retaining-portion accommodating groove 41 above the retaining-portion supporting shaft 47 and biases the retaining portion 33 in a direction at an angle different from 0° or 180°, preferably substantially orthogonal to the inserting direction of the connector housing 20 to hold the retaining portion 33 in the unlocking posture.

Specifically, when the holder 30 is set to the second position 2P with the connector housing 20 at least partly inserted in the accommodating recess 34 of the holder 30, the retaining portion 33 is in the locking posture in which an L-shaped part thereof substantially is in contact with the surfaces where the retaining-portion accommodating groove 41 and the accommodating recess 34 are formed and a leading end portion of the retaining portion 33 locks the respective opening edges of the terminal accommodating portions 21 of the connector housing 20 inserted in the accommodating recess 34. When the holder 30 is set to the first position 1 P, the retaining portion 30 particularly is pushed out of the retaining-portion accommodating groove 41 by the retaining portion spring 48 and set to the unlocking posture in which the connector housing 20 accommodated in the accommodating recess 34 can be taken out.

The lock-portion accommodating recess 38 particularly is so formed at a position of the holder 30 somewhat displaced toward the center from the lower surface as to have the same rectangular cross section up to a position somewhat displaced toward the opposite surface from the center of the holder 30 in a shorter side direction, and a lock portion 49 particularly having a substantially rectangular parallelepipedic shape and/or including an unlock sliding portion 49A at its leading end is at least partly accommodated therein slidably in a direction at an angle different from 0° or 180°, preferably substantially orthogonal to the sliding direction of the holder 30.

This unlock sliding portion 49A particularly is formed to be inclined toward the lower surface of the lock portion 49 from a position somewhat displaced toward the center from the leading end of the lock portion 49 to the leading end.

This lock portion 49 particularly is slidable between a lock position where it projects from the lock-portion accommodating recess 38 to be engaged with an unlock portion 50 formed in the base portion 60 and/or an non-lock position where it is substantially completely accommodated in the lock-portion accommodating recess 38, and biased toward the lock position by a locking spring 51 arranged between the lock portion 49 and a back wall 38A of the lock-portion accommodating recess 38.

The unlock portion 50 particularly substantially has a narrow and long rectangular parallelepipedic shape and/or held in an unlock-portion accommodating portion 67 formed in the base portion 60. The unlock-portion accommodating portion 67 is formed integrally or unitarily to the holder accommodating portion 61 at the side of the surface of the holder 30 where the lock portion 49 and the stopper 42 are provided, substantially extends in the sliding direction of the holder 30 and/or is shaped substantially in conformity with the unlock portion 50.

The unlock portion 50 includes a lock main body 52 formed with an engaging recess 53 engageable with the lock portion 49 and/or having a substantially rectangular opening and an engaging groove 54 engageable with the stopper 42 and having a substantially circular opening, an unillustrated locking projection for retaining the unlock portion 50 in the holder accommodating portion 61, and a pressing portion 55 used to at least partly insert the unlock portion 50 into the holder accommodating portion 61, and is slidable substantially in the same direction as the holder 30.

The unlock portion 50 particularly includes the pressing portion 55 at a position projecting from the surface of the holder 30 where the accommodating recess 34 is formed, and this pressing portion 55 particularly is formed to slightly project from the base portion 60 toward a side substantially opposite to the holder 30. An unlocking spring 56 is mounted below the unlock portion 50, which is biased by the unlocking spring 56.

The unlock portion 50 is slidable substantially between a non-unlock position where it is biased by the unlocking spring 56 and the pressing portion 55 completely projects from the upper surface of the base portion 60 and an unlock position where the pressing portion 55 is pressed downwardly to insert the unlock portion 50 into the unlock-portion accommodating portion 67 and slightly projects from the upper surface of the base portion 60, and a sliding direction thereof is the same as that of the holder 30.

Here, when the unlock portion 50 is at the non-unlock position and the holder 30 is slid to the second position 2P, the engaging recess 53 and the engaging groove 54 of the lock main body 52 are arranged at positions substantially corresponding to the lock portion 49 and the stopper 42 of the holder 30, and the lock portion 49 biased by the locking spring 51 locks the holder 30 at the second position 2P at the lock position where it is engaged with the engaging recess 53.

In this state, when the one or more terminal fittings 10 are at least partly inserted into the connector housing 20 at least partly inserted in the accommodating recess 34 of the holder 30 and the detection arm 32 is brought to the insufficient insertion detecting posture by the locking piece(s) 23 of the connector housing 20, the stopper 42 is engaged with the engaging groove 54 to prevent a sliding movement of the unlock portion 50.

However, when the detection arm 32 is in the non-detecting posture, the stopper 42 is at the non-restricting position and the pressing portion 55 of the unlock portion 50 can be pressed downward or outward from above to slide the unlock portion 50 to the unlock position, the upper inner surface of the engaging recess 53 pushes the lock portion 49 into the lock-portion accommodating recess 38 to slide the lock portion 49 to the non-lock position while substantially sliding in contact with the unlock sliding portion 49A of the lock portion 49. In this way, the locked state of the holder 30 is canceled, the holder 30 is or can be slid from the second position 2P to the first position 1 P and the retaining portion 33 engaged with the peripheral edge portion of the connector housing 20 is displaced to the unlocking posture, so that the connector housing 20 can be taken out from the accommodating recess 34.

The lock portion 49, the unlock portion 50 and the stopper 42 shown here correspond to a particular locking mechanism.

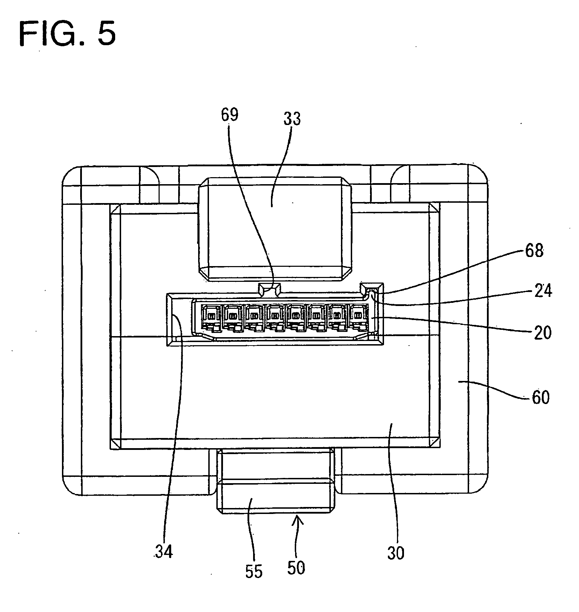

As shown in FIGS. 5 to 7, the accommodating recess 34 formed in the holder 30 is formed with at least one positioning groove 68 in at least one inner surface (particularly substantially along the longer side of the opening thereof). This positioning groove 68 extends substantially straight from the opening of the accommodating recess 34 to the bottom wall 35 of the accommodating recess 34 in the inserting direction of the connector housing 20 and/or is shaped to include, at one end of the side surface along the longer side, an inner side surface substantially flush and continuous with and integral or unitary to the inner side surface along the short side. The depth of this groove is, for example, set to less than about half (e.g. at about ¼) of the thickness of the connector housing 20 to be inserted into the accommodating recess 34, and/or the width thereof is, for example, set to be more than the groove depth, e.g. at about 1.5-fold of the groove depth.

Specifically, the connector housing 20 having at least one positioning rib 24 formed on at least one side surface (particularly substantially along the longer side) and/or substantially continuous with and integral or unitary to the side surface along the shorter side is at least partly inserted into this accommodating recess 34, and the side surface along the shorter side where the positioning rib 24 is provided particularly is set to be thicker than the connector housing 20, e.g. at about 1.3-fold of the thickness of the connector housing 20.

Thus, a connector housing 20 including one or more (e.g. eight) terminal accommodating portions 21, for example, as shown in FIG. 5 and to be at least partly inserted into the accommodating recess 34 of the holder 30 can be at least partly accommodated into the accommodating recess 34 by at least partly fitting or inserting and sliding at least one corresponding positioning rib 24 into and substantially along the respective at least one positioning groove 68 formed in the accommodating recess 34.

When the connector housing 20 is correctly (particularly completely) inserted into the accommodating recess 34, the outer side surface of the connector housing 20 where the positioning rib 24 is provided and the inner side surface of the accommodating recess 34 where the positioning groove 68 is provided are held in close contact. A surface contact area is higher (e.g. by about 1.3 times or more as large) as compared with the case where the positioning groove 68 is not provided.

A small connector assisting groove 69 having the same shape as the positioning groove 68 is formed in a longitudinal central part of the accommodating recess 34. Into this small connector assisting groove 69 is inserted at least one positioning rib 24 of a small connector housing 20A dimensioned particularly such that a side surface thereof opposite to the positioning rib 24 is held substantially in close contact with the inner side surface of the accommodating recess 34 substantially opposite to the one where the positioning groove 68 is formed when the connector housing 20A is at least partly inserted into the accommodating recess 34.

Accordingly, two small connectors can be simultaneously assembled by preparing two small connector housings 20A and at least partly inserting them while fitting positioning ribs 24 thereof into the positioning groove 68 and the small connector assisting groove 69 of the accommodating recess 34.

The connector assembling jig of this embodiment is constructed as described. Next, a connector assembling procedure and its functions and effects are described.

First, the base portion 60 of the connector assembling jig is fixed or held to or positioned on a work table and, as shown in FIG. 8, the connector housing 20 including the positioning rib 24 is at least partly inserted into the accommodating recess 34 with the holder 30 held at the first position 1 P. Subsequently, the holder 30 having the connector housing 20 inserted therein is pushed into the holder accommodating portion 61 of the base portion 60 and the holder 30 is slid or displaced towards or to the second position 2P. At this time, the lock portion 49 is engaged with the engaging recess 53 of the unlock portion 50 to lock the holder 30 at the second position 2P and the retaining portion 33 is set to the locking posture to lock the peripheral edge portion of the connector housing 20. In this way, the connector housing 20 is retained in the accommodating recess 34.

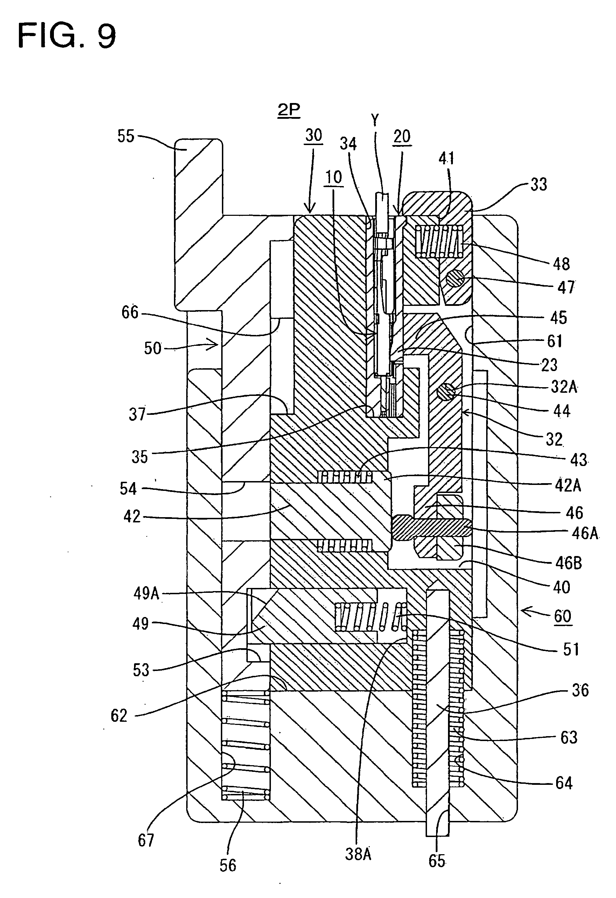

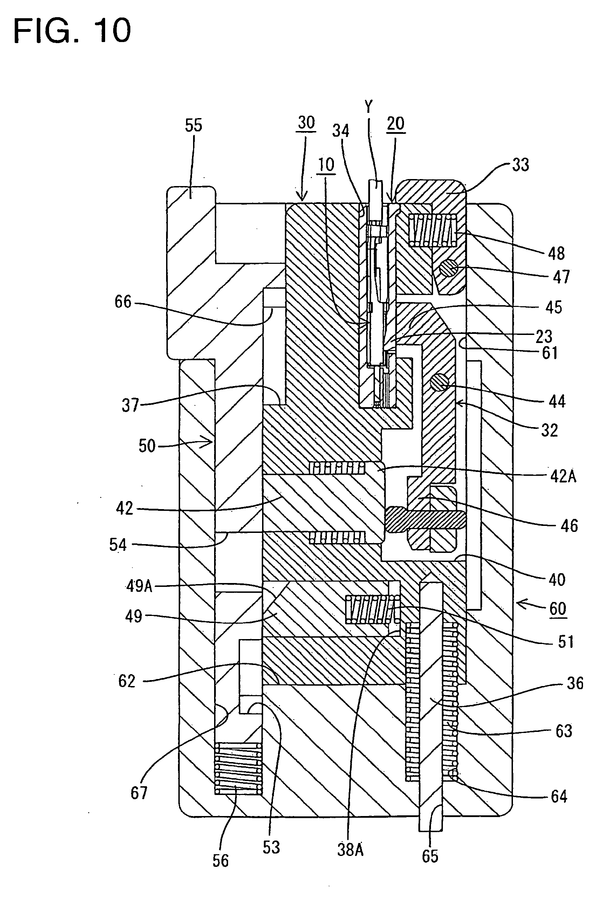

In this state, as shown in FIG. 9, the one or more terminal fittings 10 are inserted to the proper positions into the one or more terminal accommodating portions 21 of the connector housing 20. Here, since the one or more terminal fittings 10 are at the proper positions, the one or more locking pieces 23 of the connector housing 20 do not project from the outer surface of the connector housing 20 and the detection arm 32 is in the non-detecting posture. In this state, as shown in FIG. 10, the pressing portion 55 of the unlock portion 50 is pushed to slide the unlock portion 50 to the unlock position, whereby the upper surface of the engaging recess 53 pushes the lock portion 49 into the lock-portion accommodating recess 38 to slide or displace the lock portion 49 to the non-lock position substantially while substantially sliding in contact with the unlock sliding portion 49A. Then, the holder 30 locked or positioned at the second position 2P by the lock portion 49 is slid or displaced toward or to the first position 1 P particularly by a biasing force of the holder pressing spring 63 and the connector housing 20 can be taken out from the accommodating recess 34 of the holder 30.

In this way, an operator can confirm that the one or more terminal fittings 10 were inserted to the proper positions in the respective terminal accommodating portions 21. Then, the completed connector is taken out and a connector assembling operation can be performed by repeating the above operation.

However, if the terminal fitting 10 is not inserted to the proper position and left insufficiently inserted as shown in FIG. 11, the respective locking piece 23 projects from the outer surface of the connector housing 20 to push the locking-piece contact portion 45 of the detection arm 32 and the detection arm 32 is displaced toward or to the insufficient insertion detecting posture. Then, the locking-mechanism contact portion 46 of the detection arm 32 pushes the stopper 42 from the side of the detection-arm accommodating groove 40 toward the unlock portion 50, whereby the stopper 42 is engaged with the engaging groove 54, making it impossible to slide the unlock portion 50 at the non-lock position. The operator can confirm that the terminal fitting 10 is insufficiently inserted in the terminal accommodating portion 21 by noticing that the unlock portion 50 cannot be operated.

As described above, in this embodiment, resilient deformations of the locking pieces 23 of the connector housing 20 are important to indicate insufficiently inserted states of the terminal fittings 10, and it is a serious problem in detecting the inserted states of the terminal fittings that the projecting amounts of the locking pieces 23 increase or decrease from a detectable standard.

In this respect, in this embodiment, when the connector housing 20 including the positioning rib 24 is completely inserted into the accommodating recess 34 including the positioning groove 68, the outer side surface of the connector housing 20 where the positioning rib 24 is provided and the inner side surface of the accommodating recess 34 where the positioning groove 68 is provided are largely in contact, wherefore the connector housing 20 can be prevented from shaking by being inclined in the width direction and the shaking of the connector housing 20 when the terminal fittings 10 are assembled into the connector housing 20 can also be dealt with.

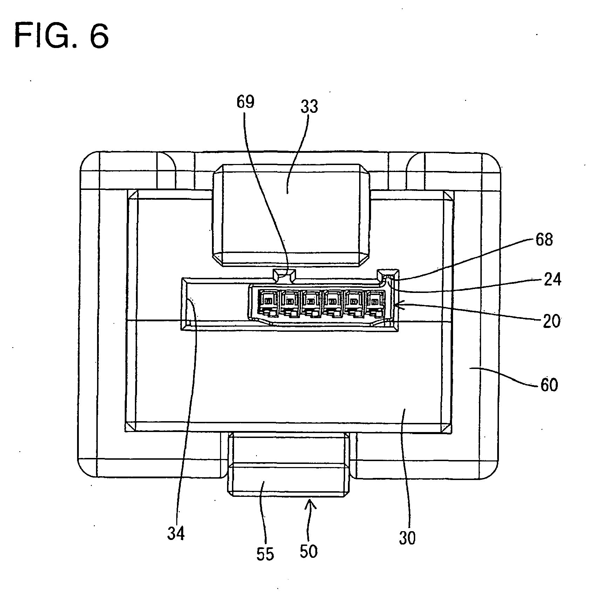

Even a connector housing 20 at least partly insertable into the accommodating recess 34, having a width shorter than a predetermined width and including fewer terminal accommodating portions 21, e.g. a connector housing 20 including six terminal accommodating portions as shown in FIG. 6 can be prevented from shaking by fitting a positioning rib 24 thereof into the positioning groove 68 of the accommodating recess 34. The jig of this embodiment can be commonly used for assembling connectors with fewer terminal accommodating portions.

Further, when a plurality of (e.g. two) small connector housings 20A are or may be simultaneously inserted into the accommodating recess 34 by at least partly fitting or inserting the positioning ribs 24 thereof into the at least one positioning groove 68 and the at least one small connector assisting groove 69, the small connector housing 20A having the positioning rib 24 at least partly inserted into the positioning groove 68 is prevented from shaking for the reason mentioned above and the one having the positioning rib 24 at least partly inserted into the small connector assisting groove 69 can be prevented from shaking by the close contact of the side surface opposite to the one where the positioning rib 24 is provided with the inner side surface of the accommodating recess 34 substantially opposite to the one where the positioning groove 69 is provided.

As described above, in this embodiment, the shaking of the connector housing 20 inserted into the accommodating recess 34 can be prevented not only when the connector housing 20 includes a predetermined number of terminal accommodating portions, but also when the connector housing 20 includes fewer terminal accommodating portions than the predetermined terminal accommodating portions. Thus, the projecting amounts of the locking pieces 23 can be prevented from increasing or decreasing from the predetermined standard, wherefore the insufficiently inserted states of the terminal fittings can be more accurately detected.

Accordingly, to provide an assembling jig which can improve accuracy of a detecting function by eliminating the shaking of a connector housing arranged in an accommodating recess and can be commonly used for connector housings with different number of terminal accommodating portions, a connector assembling jig is to be used for a connector housing 20 which includes a housing main body 22 with one or more terminal accommodating portions 21 and one or more locking pieces 23 for locking one or more respective terminal fittings 10 in the respective terminal accommodating portions 21 and in which the (particularly each) locking piece 23 projects from the housing main body 22 in an insufficient inserted state of the corresponding terminal fitting 10, and can detect insufficient insertion of the terminal fitting 10 when the terminal fitting 10 is at least partly inserted into the terminal accommodating portion 21. The connector assembling jig is provided with a holder 30 including an accommodating recess 34 for the connector housing 20 and a detection arm 32 which is set to an insufficient insertion detecting posture when any locking piece 23 projects, and the accommodating recess 34 is formed with at least one positioning groove 68 for receiving at least one (respective) positioning rib 24 of the connector housing 20.

### <Other Embodiments>

The present invention is not limited to the above described and illustrated embodiment. For example, the following embodiments are also included in the technical scope of the present claims.
(1) In the above embodiment, the depth of the positioning groove 68 of the accommodating recess 34 is about 1/4 of the thickness of the connector housing 20 to be inserted into the accommodating recess 34. However, the present invention is not limited to such a mode and the depth of the positioning groove 68 may be larger than 1/4 of the thickness of the connector housing 20.
(2) Although the accommodating recess 34 is formed with the small connector assisting groove 69 in the above embodiment, the present invention is not limited to such a mode and the accommodating recess 34 may be formed with no small connector assisting groove.

## Claims

1. A connector assembling jig which is usable for a connector housing (20) comprising:
a holder (30) including an accommodating recess (34) for at least partly accommodating the connector housing (20) while positioning the connector housing (20),
a base portion (60) including a holder accommodating portion (61) for at least partly accommodating the holder (30), and
an insufficient insertion detecting mechanism (32) for detecting that a terminal fitting (10) is insufficiently inserted in the connector housing (20), wherein the insufficient insertion detecting mechanism (32) is provided in the holder (30) and is set to an insufficient insertion detecting state when a locking piece (23) of the connector housing (20) projects outward from the one side surface of a housing main body (22) of the connector housing (20),
wherein:
the holder is slidable in the holder accommodating portion (61) between a first position (1 P) and a second position (2P), wherein in the first position (1 P) one end of the holder at an opening side projects from an opening of the base portion (60) so that the connector housing (20) can be at least partly inserted into the accommodating portion (61), and wherein in the second position (2P), the holder is substantially completely accommodated in the holder accommodating portion (61),
at least one positioning groove (68) adapted to receive at least one positioning rib (24) projecting in a thickness direction of the connector housing (20) is formed in an inner side surface of the accommodating recess (34), and
an inner surface of the positioning groove (68) is formed to substantially be flush and continuous with an inner side surface of the accommodating recess (34) adjacent to the inner side surface where the positioning groove (68) is formed.

2. A connector assembling jig according to claim 1, wherein the positioning groove (68) substantially extends in an inserting direction of the connector housing (20) from the opening edge of the accommodating recess (34).

3. A connector assembling jig according to any one of the preceding claims, wherein at least one small connector assisting groove (69) having the same shape as the positioning groove (68) is provided in a central part of the side surface of the accommodating recess (34) where the positioning groove (68) is formed.

4. A connector assembling jig according to any one of the preceding claims, wherein the insufficient insertion detecting mechanism (32) comprises a detection arm supported rotatably about a supporting shaft (44) provided in the holder (30) and displaceable between an insufficient insertion detecting posture and a non-detecting posture according a projecting state of the locking piece (23) from the housing main body (22) when the terminal fitting (10) is inserted into the connector housing (20) preferably with the holder (30) at the second position (2P).

5. A connector assembling jig according to claim 4, wherein the connector assembling jig further comprises a locking mechanism (31) which is provided from the holder (30) to the base portion (60) for locking the holder (30) at the second position (2P) when the detection arm (32) is in the detecting posture, and enables the holder (30) to slide toward or to the first position (1 P) when the detection arm (32) is in the non-detecting posture.

6. A connector assembling jig according to claim 4 or 5, wherein the detection arm (32) includes a locking-piece contact portion (45) which can come into contact with the one or more locking pieces (23) and a locking-mechanism contact portion (46) which acts on the locking mechanism (31) depending on the detecting posture.

7. A connector assembling jig according to claim 6, wherein a dimension from the supporting shaft (44) to the locking-mechanism contact portion (46) is longer than a dimension from the supporting shaft (44) to the locking-piece contact portion (45).

8. A connector assembling jig according to claim 6 or 7, wherein the locking mechanism (31) includes a lock portion (49) provided in the holder (30) and slidable in a direction crossing a sliding direction of the holder (30) between a lock position where the lock portion (49) is engaged with an engaging recess (53) formed in the base portion (60) to lock the holder (30) at the second position (2P) when the holder (30) is slid to the second position (2P) and a non-lock position where the lock portion (49) is disengaged from the engaging recess (53) to unlock the holder (30).

9. A connector assembling jig according to claim 8, wherein the locking mechanism (31) further includes an unlock portion (50) provided in the base portion (60) and slidable in the substantially same direction as the holder (30) between an unlock position where the unlock portion slides in contact with an unlock sliding portion (49A) provided at the leading end of the lock portion (49) to slide the lock portion (49) in a direction substantially opposite to an engaging direction with the engaging recess (53), thereby disengaging the engaging recess (53) and the lock portion (49), and a non-unlock position where the unlock portion (50) is fixed in the base portion (60) and holds the lock portion (49) and the engaging recess (53) in a locked state.

10. A connector assembling jig according to claim 9, wherein the locking mechanism (31) includes a stopper (42) provided in the holder (30) and slidable in the substantially same direction as the lock portion (49) between a restricting position where the stopper (42) is engaged with an engaging groove (54) formed in the base portion (60) and restricts the unlock portion (50) at the non-unlock position by being pushed by the detection arm (32) when the detection arm (32) is in the detecting posture and a non-restricting position where the stopper (42) is disengaged from the engaging groove (54) to free the unlock portion.

11. A connector assembling jig according to claim 10, wherein a stopper biasing member (43) is supported on the stopper (42) for biasing stopper (42) toward a detection-arm accommodating groove (40) of the holder (30).

12. A connector assembling jig according to any one of the preceding claims, wherein the holder (30) includes a retaining portion (33) for retaining the connector housing (20) inserted in the holder (30) preferably when the holder (30) is at the second position (2P).

13. A connector assembling jig according to any one of the preceding claims, wherein the positioning groove (68) has a depth which is set to less than about half of a thickness of the connector housing (20) to be inserted into the accommodating recess (34), and/or the width of the positioning groove (68) is set to be more than a depth of the positioning groove (68).

## Patentansprüche

1. Verbindermontagevorrichtung, die für ein Verbindergehäuse (20) verwendbar ist, die umfasst:
eine Halterung (30) mit einer Aufnahmeaussparung (34), um das Verbindergehäuse (20) wenigstens teilweise aufzunehmen, während das Verbindergehäuse (20) positioniert wird,
einen Basisabschnitt (60), der einen Halterungsaufnahmeabschnitt (61) umfasst, um die Halterung (30) wenigstens teilweise aufzunehmen, und
einen Erkennungsmechanismus (32) für unzureichendes Einsetzen, um zu erkennen, dass ein Anschlussstück (10) unzureichend in das Verbindergehäuse (20) eingesetzt ist, wobei der Erkennungsmechanismus (32) für unzureichendes Einsetzen in der Halterung (30) bereitgestellt ist und auf einen Erkennungszustand für das unzureichende Einsetzen festgelegt ist, wenn ein Sperr- bzw. Arretierstück (23) des Verbindergehäuses (20) von der einen Seitenfläche eines Gehäusehauptkörpers (22) des Verbindergehäuses (20) vorsteht,
wobei:
die Halterung in dem Halterungsaufnahmeabschnitt (61) zwischen einer ersten Position (1 P) und einer zweiten Position (2P) verschiebbar ist, wobei in der ersten Position (1 P) ein Ende der Halterung auf einer Öffnungsseite von einer Öffnung des Basisabschnitts (60) vorsteht, so dass das Verbindergehäuse (20) wenigstens teilweise in den Aufnahmeabschnitt (61) eingesetzt werden kann, und wobei die Halterung in der zweiten Position (2P) im Wesentlichen vollständig in dem Halterungsaufnahmeabschnitt (61) aufgenommen ist,
wenigstens eine Positionierungsrille (68), die geeignet ist, wenigstens eine Positionierungsrippe (24), die in einer Dickenrichtung des Verbindergehäuses (20) vorsteht, in einer Innenseitenfläche der Aufnahmeaussparung (34) ausgebildet ist, und
eine Innenfläche der Positionierungsrille (68) derart ausgebildet ist, dass sie im Wesentlichen bündig und zusammenhängend mit einer Innenseitenfläche der Aufnahmeaussparung (34) benachbart zu der Innenseitenfläche ist, wo die Positionierungsrille (68) ausgebildet ist.

2. Verbindermontagevorrichtung nach Anspruch 1, wobei die Positionierungsrille (68) sich von dem Öffnungsrand der Aufnahmeaussparung (34) im Wesentlichen in einer Einsetzrichtung des Verbindergehäuses (20) erstreckt.

3. Verbindermontagevorrichtung nach einem der vorhergehenden Ansprüche, wobei die wenigstens eine kleine Verbinderunterstützungsrille (69), die die gleiche Form wie die Positionierungsrille (68) hat, in einem mittleren Teil der Seitenfläche der Aufnahmeaussparung (34) bereitgestellt ist, wo die Positionierungsrille (68) ausgebildet ist.

4. Verbindermontagevorrichtung nach einem der vorhergehenden Ansprüche, wobei der Erkennungsmechanismus (32) für unzureichendes Einsetzen einen Erkennungsarm umfasst, der drehbar um einen in der Halterung (30) bereitgestellten Halteschaft gehalten wird und zwischen einer Erkennungsstellung und einer Nichterkennungsstellung für das unzureichende Einsetzen entsprechend einem vorstehenden Zustand des Sperrstücks (23) von dem Gehäusehauptkörper (22) verschiebbar ist, wenn das Anschlussstück (10) in das Verbindergehäuse (20) vorzugsweise mit der Halterung (30) in der zweiten Position (2P) eingesetzt wird.

5. Verbindermontagevorrichtung nach Anspruch 4, wobei die Verbindermontagevorrichtung ferner einen Sperrmechanismus (31) umfasst, der von der Halterung (30) zu dem Basisabschnitt (60) bereitgestellt ist, um die Halterung (30) an der zweiten Position (2P) zu sperren, wenn der Erkennungsarm (32) in der Erkennungsstellung ist, und ermöglicht, dass die Halterung (30) in Richtung der oder in die erste Position (1 P) gleitet, wenn der Erkennungsarm (32) in der Nichterkennungsstellung ist.

6. Verbindermontagevorrichtung nach Anspruch 4 oder 5, wobei der Erkennungsarm (32) einen Sperrstück-Kontaktabschnitt (45), der mit dem einen oder den mehreren Sperrstücken (23) in Kontakt kommen kann, und einen Sperrmechanismus-Kontaktabschnitt (46) umfasst, der abhängig von der Erkennungsstellung auf den Sperrmechanismus (31) wirkt.

7. Verbindermontagevorrichtung nach Anspruch 6, wobei eine Abmessung von dem Halteschaft (44) zu dem Sperrmechanismus-Kontaktabschnitt (46) länger als eine Abmessung von dem Halteschaft (44) zu dem Sperrstück-Kontaktabschnitt (45) ist.

8. Verbindermontagevorrichtung nach Anspruch 6 oder 7, wobei der Sperrmechanismus (31) einen Sperrabschnitt (49) umfasst, der in der Halterung (30) bereitgestellt ist und in eine Richtung verschiebbar ist, die eine Verschiebungsrichtung der Halterung (30) zwischen einer Sperrposition, in welcher der Sperrabschnitt (49) mit einer Eingreifaussparung (53) in Eingriff ist, die in dem Basisabschnitt (60) ausgebildet ist, um die Halterung (30) an der zweiten Position (2P) zu sperren, wenn die Halterung (30) in die zweite Position (P2) verschoben wird, und einer Nichtsperrposition, in welcher der Sperrabschnitt (49) von der Eingreifaussparung (53) gelöst wird, um die Halterung (30) zu entsperren, kreuzt.

9. Verbindermontagevorrichtung nach Anspruch 8, wobei der Sperrmechanismus (31) ferner einen Entsprerrabschnitt (50) umfasst, der in dem Basisabschnitt (60) bereitgestellt ist und im Wesentlichen in der gleichen Richtung wie die Halterung (30) zwischen einer Entsperrposition, in welcher der Entsperrabschnitt gleitet, in Kontakt mit einem Entsperrgleitabschnitt (49A), der an dem führenden Ende des Sperrabschnitts (49) bereitgestellt ist, um den Sperrabschnitt (49) in eine Richtung im Wesentlichen entgegengesetzt zu einer Eingreifrichtung mit der Eingreifaussparung (53), wodurch die Eingreifaussparung (53) und der Sperrabschnitt (49) gelöst werden, und einer Nichtentsperrposition, in welcher der Entsperrabschnitt (50) in dem Basisabschnitt (60) fixiert ist und den Sperrabschnitt (49) und die Eingreifaussparung (53) in einem gesperrten Zustand hält, zu verschieben.

10. Verbindermontagevorrichtung nach Anspruch 9, wobei der Sperrmechanismus (31) einen Anschlag (42) umfasst, der in der Halterung (30) bereitgestellt ist und im Wesentlichen in der gleichen Richtung wie der Sperrabschnitt (49) verschiebbar ist zwischen einer Beschränkungsposition, in welcher der Anschlag (42) mit einer in dem Basisabschnitt (60) ausgebildeten Eingreifrille (54) in Eingriff ist und den Entsperrabschnitt (50) in der Nichtentsperrposition beschränkt, indem er durch den Erkennungsarm (32) gedrückt wird, wenn der Erkennungsarm (32) in der Erkennungsstellung ist, und einer Nichterkennungsposition, in welcher der Anschlag (42) von der Eingreifrille (54) gelöst ist, um den Entsperrabschnitt zu lösen.

11. Verbindermontagevorrichtung nach Anspruch 10, wobei ein Anschlag-Vorspannelement (43) auf dem Anschlag (42) zum Vorspannen des Anschlags (42) in Richtung einer Erkennungsarm-Aufnahmerille (40) der Halterung (30) gehalten wird.

12. Verbindermontagevorrichtung nach einem der vorhergehenden Ansprüche, wobei die Halterung (30) einen Rückhalteabschnitt (33) zum Zurückhalten des Verbindergehäuses (20) umfasst, das vorzugsweise in die Halterung (33) eingesetzt ist, wenn die Halterung in der zweiten Position (2P) ist.

13. Verbindermontagevorrichtung nach einem der vorhergehenden Ansprüche, wobei die Positionierungsrille (68) eine Tiefe hat, die auf weniger als etwa die Hälfte einer Dicke des Verbindergehäuses (20) festgelegt ist, um in die Aufnahmeaussparung (34) eingesetzt zu werden, und/oder wobei die Breite der Positionierungsrille (68) derart festgelegt ist, dass sie größer als eine Tiefe der Positionierungsrille (68) ist.

## Revendications

1. Outillage d'assemblage de connecteur qui peut être utilisé pour un boîtier de connecteur (20), comprenant :
un support (30) comportant une cavité de réception (34) destinée à recevoir au moins partiellement le boîtier de connecteur (20) tout en assurant le positionnement du boîtier de connecteur (20),
une partie de base (60) comportant une partie de réception de support (61) destinée à recevoir au moins partiellement le support (30), et
un mécanisme de détection d'insertion insuffisante (32) destiné à détecter le fait qu'un raccord de borne (10) est insuffisamment inséré dans le boîtier de connecteur (20), dans lequel le mécanisme de détection d'insertion insuffisante (32) est agencé sur le support (30) et est placé dans un état de détection d'insertion insuffisante lorsqu'une pièce de verrouillage (23) du boîtier de connecteur (20) s'étend en saillie vers l'extérieur à partir de la première surface latérale d'un corps principal de boîtier (22) du boîtier de connecteur (20),
dans lequel :
le support peut coulisser dans la partie de réception de support (61) entre une première position (1P) et une deuxième position (2P), dans lequel, dans la première position (1P), une extrémité du support au niveau d'un côté d'ouverture s'étend en saillie à partir d'une ouverture de la partie de base (60) de telle sorte que le boîtier de connecteur (20) peut être au moins partiellement inséré dans la partie de réception (61), et dans lequel, dans la seconde position (2P), le support est reçu sensiblement entièrement dans la partie de réception de support (61),
au moins une rainure de positionnement (68), adaptée afin de recevoir au moins une nervure de positionnement (24) s'étendant dans le sens de l'épaisseur du boîtier de connecteur (20), est formée sur une surface latérale interne de la cavité de réception (34), et
une surface interne de la rainure de positionnement (68) est formée de manière à être sensiblement au raz d'une surface latérale interne de la cavité de réception (34) et continue par rapport à celle-ci, de manière adjacente à la surface latérale interne sur laquelle la rainure de positionnement (68) est formée.

2. Outillage d'assemblage de connecteur selon la revendication 1, dans lequel la rainure de positionnement (68) s'étend sensiblement dans une direction d'insertion du boîtier de connecteur (20) à partir du bord d'ouverture de la cavité de réception (34).

3. Outillage d'assemblage de connecteur selon l'une quelconque des revendications précédentes, dans lequel au moins une petite rainure d'assistance de connecteur (69) présentant la même forme que la rainure de positionnement (68) est agencée sur une partie centrale de la surface latérale de la cavité de réception (34) sur laquelle la rainure de positionnement (68) est formée.

4. Outillage d'assemblage de connecteur selon l'une quelconque des revendications précédentes, dans lequel le mécanisme de détection d'insertion insuffisante (32) comprend un bras de détection supporté de manière à pouvoir tourner autour d'un arbre de support (44) agencé sur le support (30) et pouvant être déplacé entre une posture de détection d'insertion insuffisante et une posture de non-détection selon un état d'extension de la pièce de verrouillage (23) à partir du corps principal de boîtier (22) lorsque le raccord de borne (10) est inséré dans le boîtier de connecteur (20), de préférence, le support (30) étant dans la seconde position (2P).

5. Outillage d'assemblage de connecteur selon la revendication 4, dans lequel l'outillage d'assemblage de connecteur comprend, en outre, un mécanisme de verrouillage (31) qui est agencé à partir du support (30) vers la partie de base (60) afin de verrouiller le support (30) dans la seconde position (2P) lorsque le bras de détection (32) est dans la posture de détection, et permet au support (30) de coulisser vers l'avant ou la première position (1P) lorsque le bras de détection (32) est dans la posture de non détection.

6. Outillage d'assemblage de connecteur selon la revendication 4 ou 5, dans lequel le bras de détection (32) comporte une partie de contact de pièce de verrouillage (45) qui peut venir en contact avec la première ou plusieurs pièces de verrouillage (23) et une partie de contact de mécanisme de verrouillage (46) qui agit sur le mécanisme de verrouillage (31) en fonction de la posture de détection.

7. Outillage d'assemblage de connecteur selon la revendication 6, dans lequel une dimension depuis l'arbre de support (44) à la partie de contact de mécanisme de verrouillage (46) est supérieure à une dimension depuis l'arbre de support (44) à la partie de contact de pièce de verrouillage (45).

8. Outillage d'assemblage de connecteur selon la revendication 6 ou 7, dans lequel le mécanisme de verrouillage (31) comporte une partie de verrouillage (49) agencée sur le support (30) et pouvant coulisser dans une direction transversale à la direction de coulissement du support (30) entre une position de verrouillage dans laquelle la partie de verrouillage (49) est couplée à une cavité de couplage (53) formée sur la partie de base (60) afin de verrouiller le support (30) dans la seconde position (2P). lorsque le support (30) coulisse vers la seconde position (2P) et une position non verrouillée dans laquelle la partie de verrouillage (49) est séparée de la cavité de couplage (53) afin de déverrouiller le support (30).

9. Outillage d'assemblage de connecteur selon la revendication 8, dans lequel le mécanisme de verrouillage (31) comporte, en outre, une partie de déverrouillage (50) agencée dans la partie de base (60) et pouvant coulisser sensiblement dans la même direction que le support (30) entre une position de déverrouillage dans laquelle la partie de déverrouillage coulisse en contact avec une partie coulissante de déverrouillage (49A) agencée au niveau de l'extrémité avant de la partie de verrouillage (49) afin de faire coulisser la partie de verrouillage (49) dans une direction sensiblement opposée à une direction de couplage avec la cavité de couplage (53), séparant ainsi la cavité de couplage (53) et la partie de verrouillage (49), et une position non déverrouillée dans laquelle la partie de déverrouillage (50) est fixée sur la partie de base (60) et maintient la partie de verrouillage (49) et la cavité de couplage (53) dans un état verrouillé.

10. Outillage d'assemblage de connecteur selon la revendication 9, dans lequel le mécanisme de verrouillage (31) comporte un dispositif d'arrêt (42) agencé sur le support (30) et pouvant coulisser sensiblement dans la même direction que la partie de verrouillage (49) entre une position de limitation dans laquelle l'élément d'arrêt (42) est couplé dans une rainure de couplage (54) formée sur la partie de base (60) et limite la partie de déverrouillage (50) dans la position non déverrouillée en étant poussé par le bras de détection (32) lorsque le bras de détection (32) est dans la posture de détection et une position non limitée dans laquelle l'élément d'arrêt (42) est séparé de la rainure de couplage (54) afin de libérer la partie de déverrouillage.

11. Outillage d'assemblage de connecteur selon la revendication 10, dans lequel un élément d'application d'élément d'arrêt (43) est supporté sur l'élément d'arrêt (42) afin d'appliquer l'élément d'arrêt (42) vers une rainure de réception de bras de détection (40) du support (30).

12. Outillage d'assemblage de connecteur selon l'une quelconque des revendications précédentes, dans lequel le support (30) comporte une partie de retenue (33) destinée à retenir le boîtier de connecteur (20) inséré sur le support (30), de préférence, lorsque le support (30) est dans la seconde position (2P).

13. Outillage d'assemblage de connecteur selon l'une quelconque des revendications précédentes, dans lequel la rainure de positionnement (68) présente une profondeur qui est définie à moins de la moitié environ de l'épaisseur du boîtier de connecteur (20) à insérer dans la cavité de réception (34), et/ou la largeur de la rainure de positionnement (68) est définie de manière à être supérieure à la profondeur de la rainure de positionnement (68).
